# EUROPÄISCHE PATENTSCHRIFT

(11) **EP 0 458 830 B1**
(45) Veröffentlichungstag und Bekanntmachung des Hinweises auf die Patenterteilung: **06.10.1993**
(21) Anmeldenummer: 90903143.7
(22) Anmeldetag: 14.02.1990
(51) Int. Cl.: H05K 13/04

(54) **MONTAGEKOPF FÜR HANDHABUNGSGERÄTE**
ASSEMBLY HEAD FOR HANDLING DEVICES
TETE DE MONTAGE DE MANIPULATEURS

(30) Priorität: 16.02.1989 DE 3904587
(43) Veröffentlichungstag der Anmeldung: 04.12.1991
(73) Patentinhaber: ARNOLD & RICHTER CINE TECHNIK GMBH & CO. BETRIEBS KG., D-80799 München (DE)
(72) Erfinder: RAUSCHER, Erich, D-8000 München 50 (DE)
(74) Vertreter: Ninnemann, Detlef, Dipl.-Ing.
(86) Internationale Anmeldenummer: DE9000104
(87) Internationale Veröffentlichungsnummer: WO9009732

(56) Entgegenhaltungen:
- EP-A- 20 002
- EP-A- 67 233
- CH-A- 664 110
- DE-C- 3 217 672
- IBM TECHNICAL DISCLOSURE BULLETIN. vol. 32 1, Juni 1989, NEW YORK USSeiten 459-461; "PLACEMENT HEAD" siehe Seite 461, Zeilen 8-33; Figuren 2a-2c

## Beschreibung

Die Erfindung betrifft eine Vorrichtung der im Oberbegriff des Anspruchs 1 genannten Art.

Die in der Montagetechnik eingesetzten Montageköpfe für Handhabungsgeräte zum programmgesteuerten automatischen Montieren von Einzelteilen auf einem Werkstück, insbesondere zum Bestücken von Leiterplatten mit elektronischen Bauteilen (SMD-Bauteile), weisen in der Regel mehrere voneinander unabhängige, mit Stellmotoren antreibbare Achsen auf, die über Stellgetriebe einzelne Funktionseinheiten, wie z.B. Greifzangen, betätigen.

Aus der DE-C 32 17 672 ist ein Montagekopf bekannt, bei dem mehrere Funktionseinheiten unabhängig bzw. gekoppelt miteinander durch Stellgetriebe betätigt werden. Diese Funktionseinheiten bestehen aus einem um 360° drehbaren Drehstern, zwei daran befestigten Zangenpaaren, einer längsverschiebbaren, in einer zentralen Bohrung des Drehsterns geführten Pinole und einer Ausstoßvorrichtung, die dazu dient, mittels Vakuum an einer Saugpipette haftende Bauteile von der Saugpipette abzulösen bzw. die Saugpipette vakuumdicht zu verschließen.

Die Ausstoßvorrichtung wird genau wie die Zangenpaare und die längsverschiebbare Pinole über ein Stellgetriebe betätigt, dessen Bewegung über eine Kurvenscheibe gesteuert wird. Da die Ausstoßvorrichtung in Abhängigkeit von der Hubstellung der längsverschiebbaren Pinole zu betätigen ist, sind die Stellgetriebe der Ausstoßvorrichtung und der Pinole miteinander gekoppelt.

Das Stellgetriebe der Ausstoßvorrichtung ist genau wie die übrigen Stellgetriebe aus unterschiedlichen, massiv ausgeführten Getriebegliedern zusammengesetzt. Aufgrund seiner massiven Ausführung bildet das Stellgetriebe der Ausstoßvorrichtung einen beträchtlichen Anteil der von der Pinole bei jeder Hubbewegung zu bewegenden Massen. Da die maximale Hubfrequenz der Pinole begrenzt ist durch die auftretenden Massenkräfte, die oberhalb einer bestimmten Grenze zu einer schädlichen Schwingungserregung des Montagekopfs führen, wirkt sich diese massive Ausführung des Stellgetriebes nachteilig auf die erreichbaren Stückzahlen in der Produktion von Leiterplatten aus.

Der Erfindung liegt die Aufgabe zugrunde, einen Montagekopf der eingangs beschriebenen Art derart weiterzubilden, daß durch eine Reduzierung der bewegten Massen eine höhere Hubfrequenz erreichbar wird und gleichwohl ein sicherer und störunanfälliger Betrieb des Montagekopfs möglich ist.

Diese Aufgabe wird mit den kennzeichnenden Merkmalen des Anspruchs 1 gelöst.

Die Betätigung der Ausstoßvorrichtung über ein zugbelastetes Stellglied ermöglicht den Einsatz leichter, lediglich auf Zug belastbarer Materialien für die Verwendung als Stellglied. Hieraus ergibt sich eine beträchtliche Reduzierung der von der Pinole zu bewegenden Massen und somit die Möglichkeit die maximale Hubfrequenz heraufzusetzen.

Nach einer vorteilhaften Ausgestaltung der Erfindung ist das Stellglied Bestandteil des am Rahmen des Montagekopfs angelenkten Stellgetriebes zur Betätigung der Ausstoßvorrichtung. Hierbei ist das Stellglied zur kraftschlüssigen Verbindung eines über eine Kurvenscheibe angetriebenen mit einem die Ausstoßvorrichtung über Stößel betätigenden Drehhebels verbunden, wobei dieser schwenkbar in einem Drehgelenk mit einem die Verfahrbewegung der Pinole ermöglichenden Hubhebel verbunden ist.

Vorteilhafterweise werden hier anstatt massiver raumgreifender Hebel, die traversenartig im Montagekopf angeordnet sind, neben dem Stellglied lediglich kleine, einen minimalen Hub ausführende Stößel sowie ein Drehhebel, der mit dem ohnehin vorhandenen Hubhebel zum Verfahren der Pinole verbunden ist und direkt auf die Stößel wirkt, eingesetzt.

Bei einem bevorzugten Ausführungsbeispiel ist das Stellglied als Stahlband ausgeführt. Hierdurch ist eine flexible Ausführung des Stellglieds ermöglicht, die auch eine Anpassung an beengte Einbauverhältnisse erlaubt.

Zur vorteilhaften raumsparenden Anordnung der Elemente des Stellgetriebes sind der Steuerhebel und der Hubhebel einander gegenüberliegend zu beiden Seiten der Pinole angeordnet, wobei das Stahlband im Bereich des den Hubhebel aufnehmenden Schwenklagers umgelenkt ist.

Nach einer vorteilhaften Weiterbildung der Erfindung ist der Drehhebel parallel zu dem über Achsstummel an einem Hubring zum Längsverfahren der Pinole angelenkten Hubhebel angeordnet, so daß er die Achsstummel in Langlöchern seiner Schenkel aufnimmt und diese in die Mitte der axialen Hubbewegung der Ausstoßvorrichtung bringt.

Parallel zum Hubhebel ist an diesem eine einstellbare Druckfeder befestigt, die auf einen Anlenkpunkt des Stahlbands am Drehhebel wirkt, und diesen so in eine gegenüber dem Hubhebel abgeknickte Position zwingt, die für die Schwenkbewegung des Drehhebels einen Anschlag darstellt. Entgegen der Wirkung dieser Druckfeder erfolgt die Hubbewegung der Ausstoßvorrichtung. Gleichzeitig sorgt die Federkraft für eine Vorspannung des Stahlbands.

Nach einer vorteilhaften Weiterbildung endet der Umschlingungswinkel des Stahlbands am Lagermittelpunkt eines zur Lagerung des Hubhebels dienenden Schwenklagers. Hierdurch wird erreicht, daß bei einem Verschwenken des Hubhebels keine Spannungsänderung im Stahlband eintritt.

Bei einem weiteren bevorzugten Ausführungsbeispiel ist das Stellglied als Stellhebel ausgeführt. Hierdurch ist ein Stellglied geschaffen, das besonders leicht ausgeführt werden kann.

Nach einer vorteilhaften Weiterbildung verbindet der Stellhebel den Steuerhebel mit einem Schwenkhebel, der wiederum über eine Gelenkverbindung mit einer durch eine Druckfeder belastete, an den Drehhebel angelenkte Stange verbunden ist. Die Gelenkverbindung besteht hierbei vorzugsweise aus einem in einem Langloch der Stange geführten Gelenkzapfen des Schwenkhebels. Durch diese besondere Ausführung der Gelenkverbindung wird erreicht, daß unabhängig von schädlichen Toleranzen in der Kinematik des Stellgetriebes der Drehhebel bei Nichtbetätigung der Ausstoßvorrichtung stets zugentlastet ist, da die Toleranzen durch das vorhandene Spiel des Gelenkzapfens im Langloch ausgeglichen werden. Durch diese konstruktive Maßnahme ist also sichergestellt, daß die Ausstoßvorrichtung durch die gesamte Federkraft der Zugfeder belastet wird und der Vacuumverschluß sicher geschlossen wird.

Gemäß einem vorteilhaften Merkmal ist die Zugfeder auf der Stange geführt, wobei sie mit einem Ende an der Stange eingehängt ist und mit dem anderen Ende an einem mit dem Hubhebel verbundenen Widerlager hängt.

Nach einer weiteren vorteilhaften Ausgestaltung der Erfindung ist die die Austoßvorrichtung in sich aufnehmende Pinole in einer oberen und unteren Pinolenaufnahme des Montagekopfes in Wälzlagern längsverschiebbar geführt.

Hierdurch wird verhindert, daß möglicherweise durch die Stellgetriebe, insbesondere den Drehhebel, auf die Pinole wirkende Steuermomente zu einem Verkanten der Pinole in den Lagerstellen - wie es bei einer Gleitführung möglich ist - führen.

Die Pinole ist sowohl in der oberen Pinolenführung als auch in der unteren Pinolenführung, die jeweils in den Endbereichen der Pinole angeordnet sind, in Kugellagern längsverschiebbar geführt. Die so geschaffene, große Lagerbasis ermöglicht, daß auch größere Querbelastungen der Pinole sicher von den Lagern aufgenommen werden.

Die im Bereich der oberen Pinolenführung einen Kreisringquerschnitt aufweisende Pinole ist in drei, gleichmäßig über den Umfang der Pinole verteilten Kugellagern in einem Lagerhalter geführt, der wiederum in einer Kugelringführung gehalten ist zur radialen Verdrehung. Im Bereich der unteren Pinolenführung weist die Pinole einen quadratischen Querschnitt auf und ist in vier jeweils den Ecken des quadratischen Querschnitts zugeordneten Kugellagern geführt. In den Ecken des Querschnitts sind in Längsrichtung der Pinole sich erstreckende Stahlnadeln vorgesehen, auf denen die Kugellager abrollen.

Zwei der Kugellager im Bereich der unteren Pinolenführung sind als vorgespannte Doppelkugellager ausgeführt, die auf ihren Außenringen jeweils einen Führungsring aufweisen, von denen mindestens einer einen V-förmig eingeschnittenen Querschnitt aufweist zur Zweipunktanlage an eine Stahlnadel. Hinsichtlich ihres Abstandes von der Pinolenlängsachse sind die Kugellager einstellbar. Die Zweipunktanlage eines Führungsrings an eine Stahlnadel ermöglicht zusammen mit der Einstellung des radialen Andrucks der Lager an die Stahlnadeln eine exakte Ausrichtung von Pinole und Drehstern zueinander um ihre gemeinsame Längsachse.

Zudem wird durch die Zweipunktanlage eine genaue Verdrehsicherung geschaffen, ohne die Leichtgängigkeit der durch die Stahlnadeln und die Kugellager geschaffenen Linearführung der Pinole zu beeinträchtigen.

Weitere vorteilhafte Ausgestaltungen der Erfindung werden zusammen mit den bevorzugten Ausführungsbeispielen nachfolgend anhand der Figuren dargestellt. Es zeigen:
- Figur 1: einen Montagekopf mit Ausstoßvorrichtung in schematischer Darstellung,
- Figur 2: den Montagekopf in einer Schnittdarstellung,

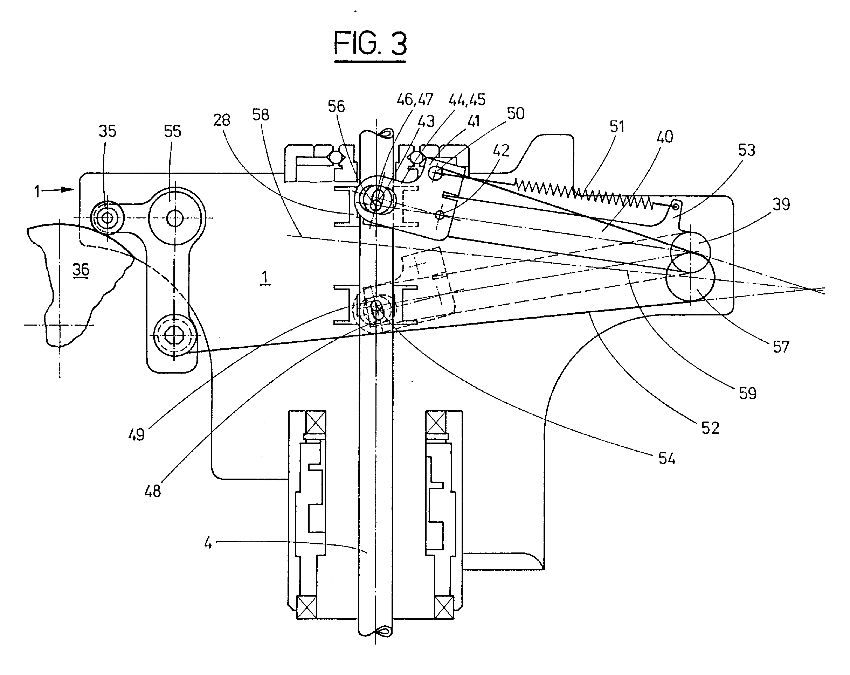

- Figur 3: ein mit einem Stahlband versehenes Stellgetriebe zur Betätigung der Ausstoßvorrichtung,

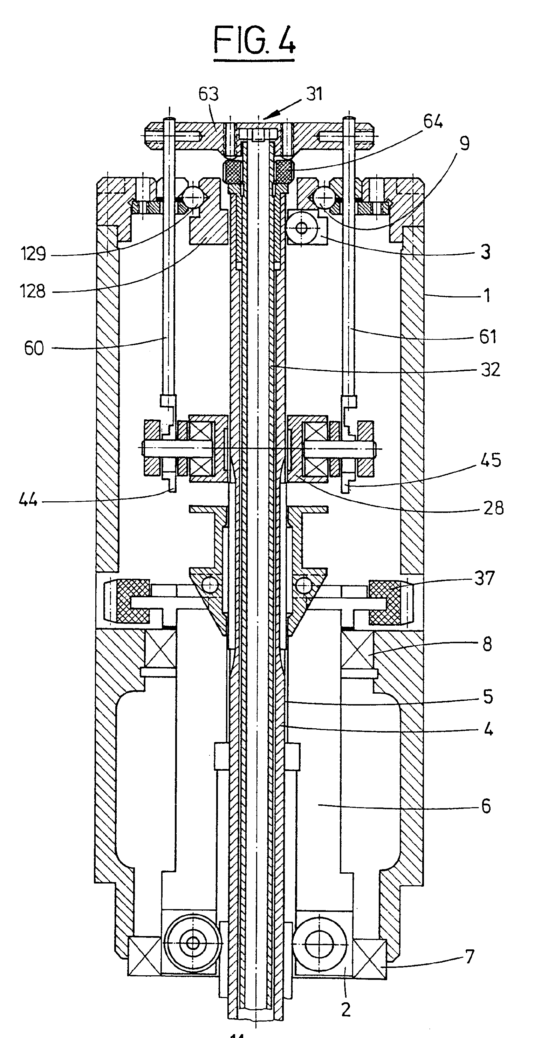

- Figur 4: einen Längsschnitt durch die Pinolenaufnahme,

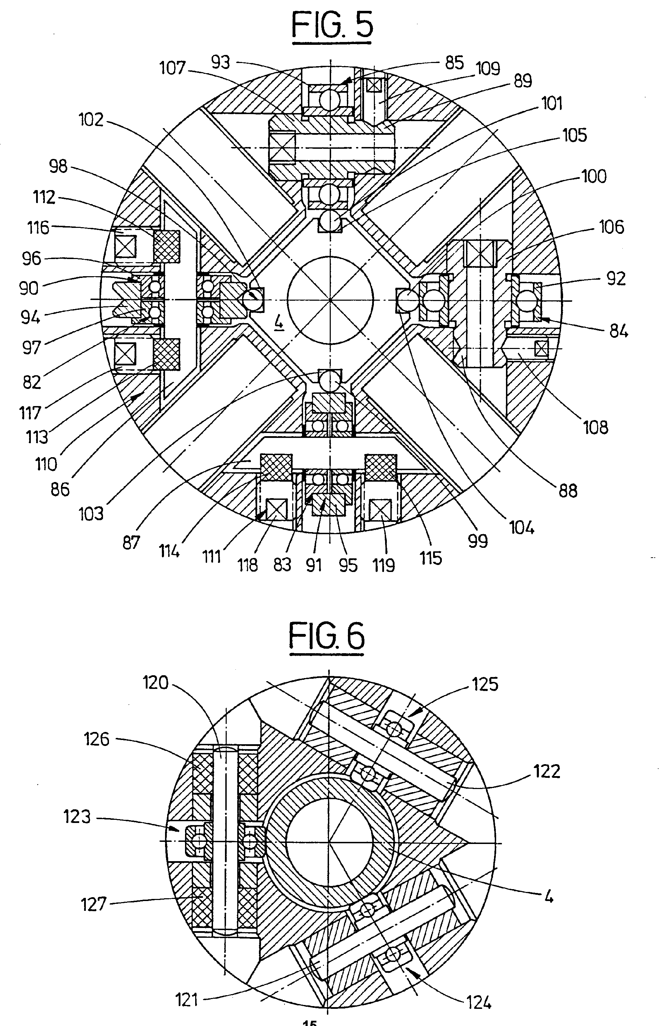

- Figur 5: eine untere Pinolenführung,
- Figur 6: eine obere Pinolenführung,

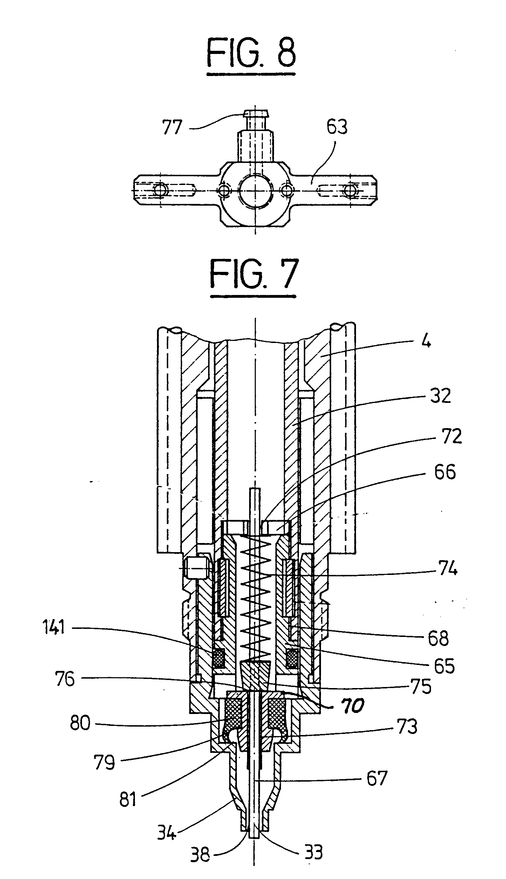

- Figur 7: eine Ausstoßvorrichtung,
- Figur 8: ein Joch zur Betätigung der Ausstoßvorrichtung und
- Figur 9: ein mit einem Stellhebel versehenes Stellgetriebe.

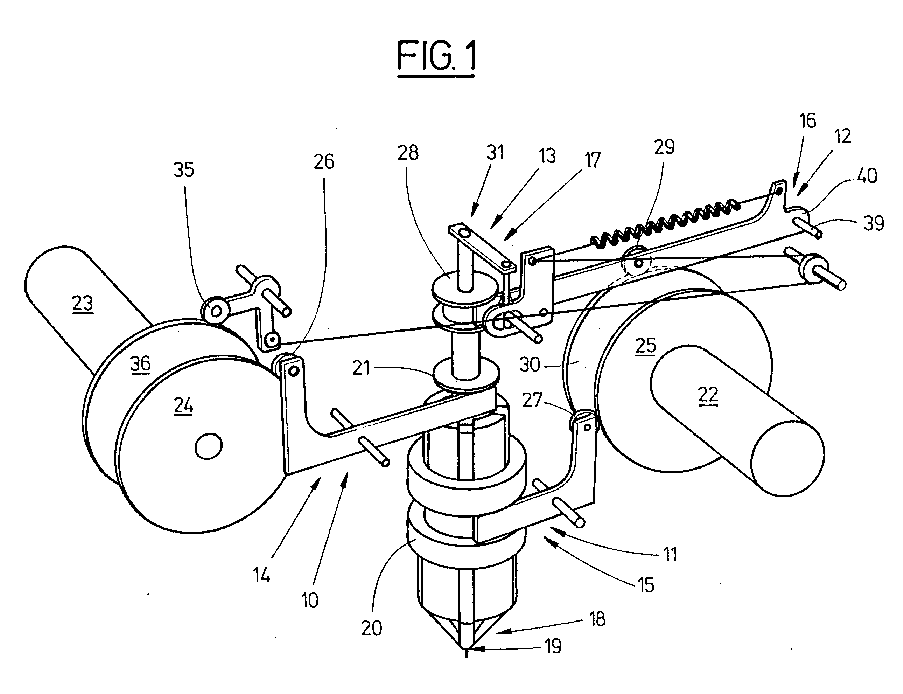

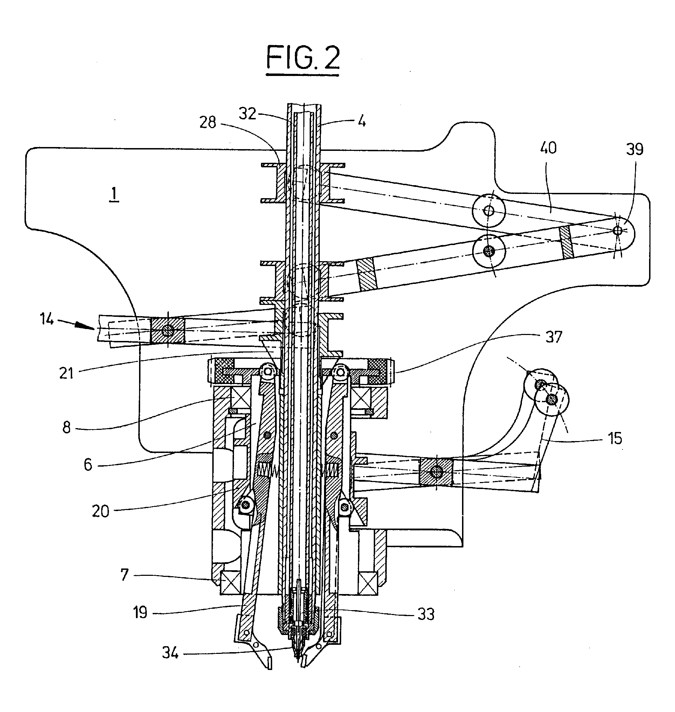

Der in den Figuren 1 und 2 perspektivisch und im Schnitt dargestellte Montagekopf zum Bestücken von Leiterplatten mit elektronischen Bauteilen besteht im wesentlichen aus einem Rahmen 1, in dem eine von einer unteren und einer oberen Pinolenführung 2, 3 aufgenommene Pinole 4 angeordnet ist, die durch eine zentrale Bohrung 5 eines Drehsterns 6 hindurchgeführt ist.

Sowohl die untere Pinolenführung 2 und die obere Pinolenführung 3 als auch der Drehstern 6 sind gegenüber dem Rahmen 1 des Montagekopfs drehbar in Wälzlagern 7, 8 und 9 gelagert. Gegenüber dem Drehstern 6 ist die Pinole 4 drehfest längsverschiebbar geführt.

Zur Aufnahme und dem anschließenden Plazieren von elektronischen Bauteilen auf Leiterplatten ist der Montagekopf mit unterschiedlichen Funktionseinheiten 10, 11, 12 und 13 versehen, die zur Ausführung der programmierten Arbeitstakte über unterschiedliche Stellgetriebe 14, 15, 16, 17 angetrieben werden.

Die mit dem Drehstern 6 schwenkbar verbundenen Funktionseinheiten 10, 11 sind als Zangenpaare 18, 19 ausgeführt, die beide auf dem Drehstern 6 längsverschiebbar geführte Muffen 20, 21 von den Stellgetrieben 14, 15 betätigt werden. Die Bewegungen der Stellgetriebe 14, 15 werden dabei von mit Stellmotoren 22, 23 angetriebenen Kurvenscheiben 24, 25, auf denen Abtastrollen 26, 27 der Stellgetriebe 14, 15 geführt sind, gesteuert.

Zur Ausführung einer Hubbewegung ist ein mit der Pinole 4 fest verbundener Hubring 28 am Stellgetriebe 16 angelenkt, dessen Abtastrolle 29 zur Steuerung der Hubbewegung auf einer von dem Stellmotor 23 angetriebenen Kurvenscheibe 30 entlangläuft.

In der Pinole 4 ist als Bestandteil einer die Funktionseinheit 13 bildenden Ausstoßvorrichtung 31 ein Ausstoßrohr 32 axial verschiebbar geführt, das an seinem unteren Ende einen Ausstoßer 33 aufnimmt, der in dem durch eine Saugpipette 34 gebildeten Ende der Pinole 4 geführt ist.

Zur Betätigung der Ausstoßvorrichtung 31 wird das Ausstoßrohr 32 mittels des Stellgetriebes 17, dessen Bewegungsablauf durch das Abrollen einer Abtastrolle 35 auf einer Kurvenscheibe 36 gesteuert wird, in Richtung auf die Saugpipette 34 in der Pinole 4 längsverschoben.

Der gesamte vom Montagekopf ausgeführte Bewegungsablauf gliedet sich in mehrere aufeinanderfolgende Arbeitsschritte. Zunächst erfolgt eine Ausrichtung des Drehsterns 6 durch einen entsprechenden Antrieb eines mit dem Drehstern 6 verbundenen Zahnrades 37 bzw. Zahnriemen-Rades, derart, daß die Zangenpaare 18, 19 radial so zu dem aufzunehmenden Bauteil ausgerichtet sind, daß eine Aufnahme des Bauteils möglich ist.

Nachfolgend wird mittels des Stellgetriebes 16 die Pinole 4 zusammen mit der Ausstoßvorrichtung 31 in Richtung auf das aufzunehmende Bauteil verfahren, wobei durch einen über das Stellgetriebe 17 ausgelösten Hub das Ausstoßrohr 32 mit dem Ausstoßer 33 nach oben verfahren wird zur Freigabe einer Saugbohrung 38 der Saugpipette 34. Infolge des nun an der Saugpipette 34 anliegenden Vakuums wird das Bauteil angesogen und zusammen mit der Pinole 4 in eine obere Pinolenposition verfahren.

Hier werden nun nacheinander über die Stellgetriebe 14, 15 die Zangenpaare 18, 19 aktiviert zum Zentrieren und Halten des Bauteils. Gleichzeitig erfolgt hierbei über das Zangenpaar 19 eine elektrische Überprüfung und Identifizierung des Bauteils.

Wenn sich der Montagekopf in der korrekten Absetzposition über der mit dem Bauteil zu bestückenden Leiterplatte befindet, werden die Zangenpaare 18, 19 geöffnet und das Bauteil mit der Pinole soweit in Richtung auf die Leiterplatte verfahren, bis es mit einer definierten Kraft darauf aufliegt. In dieser Position wird durch einen Hub der Ausstoßvorrichtung 31 in Richtung auf die Saugpipette 34 das an dieser anliegende Vakuum abgeschaltet und durch den Ausstoßer 33 das Bauteil von der Saugpipette 34 abgedrückt.

Abgesehen von den kurzen Hubbewegungen zum Verfahren des Ausstoßrohres 32 im Rahmen des Gesamtbewegungsablaufs des Montagekopfs wird das Ausstoßrohr 32 synchron, ohne Relativbewegung zur Pinole 4 zusammen mit dieser verfahren. Die Pinole 4 wird hierzu infolge einer Schwenkbewegung eines im Rahmen 1 des Montagekopfs in einem Schwenklager 39 geführten mittels des Hubrings 28 an der Pinole 4 angelenkten Hubhebels 40 axial verfahren.

Das Stellgetriebe 17 zur Durchführung der Hubbewegung der Ausstoßvorrichtung 31 ist mit dem Stellgetriebe 16 über einen Drehhebel 41 gekoppelt, der schwenkbar in einem Drehgelenk 42 am Hubhebel 40 angelenkt ist, derart, daß am Hubring 28 zur Verbindung mit dem Hubhebel 40 vorgesehene Achsstummel 43 durch die in Schenkeln 44, 45 des Drehhebels 41 angeordneten Langlöcher 46, 47 bzw. Freilöcher hindurchgeführt sind.

In einem bevorzugten Ausführungsbeispiel ist der Drehhebel 41 zur Durchführung einer hin und her gehenden Schwenkbewegung in einem Anlenkpunkt 50 sowohl mit einer Druckfeder 51 als auch mit einem auf Zug beanspruchten Stahlband 52 beaufschlagt. Ein Widerlager 53 der Druckfeder 51 ist am Hubhebel 40 angeordnet, so daß der Drehhebel 41 in eine gegenüber dem Hubhebel 40 abgeknickte Position nach unten gezwungen wird. Zusammen mit dem Drehhebel 41 werden Stößelstangen 60, 61 die über ein Joch 63 mit dem Ausstoßerrohr 32 verbunden sind nach unten bewegt, so daß ein in der mit dem Ausstoßrohr 32 verbundenen Ausstoßvorrichtung 31 angeordneter Dichtring 80 mit seiner Dichtlippe 79 gegen einen Pipettenabssaz 81 gepreßt wird zur Abdichtung des Vakuums.

Durch eine über die Kurvenscheibe 36 gesteuerte Schwenkbewegung eines Steuerhebels 55 wird über das mit dem Steuerhebel 55 verbundene Stahlband eine der Druckfeder 51 entgegengerichtete Zugkraft auf den Anlenkpunkt 50 des Stahlbands 52 am Drehhebel 41 ausgeübt, die ein Verschwenken des Drehhebels 41 in Richtung der Zugbelastung zur Folge hat.

Zur optimalen Ausnutzung des nur beschränkt zur Verfügung stehenden Raumes im Rahmen 1 des Montagekopfs sind die Elemente des Stellgetriebes 17 auf gegenüberliegenden Seiten der Pinole 4 angeordnet. Die hierzu notwendige Umlenkung des Stahlbandes 52 erfolgt in einem Umlenkpunkt 57, der unterhalb des Schwenklagers 39 des Hubhebels 40 angeordnet ist. Die Verbindungslinie 59 zwischen dem Umlenkpunkt 57 und einer Hubmittenlage 58 der Pinole 4 stellt gleichzeitig die Winkelhalbierende des Umschlingungswinkels des Stahlbands 52 um den Umlenkpunkt 57 dar. Hierdurch ist gewährleistet, daß die Zugbelastungen des Stahlbands 52 sowohl in der unteren Totlage 54 als auch in der oberen Totlage 56 gleich groß sind und keine Längenverschiebung zustande kommt.

Zur Übertragung der Schwenkbewegung des Drehhebels 41 auf das Ausstoßrohr 32 der Ausstoßvorrichtung 31 sind zwei mit dem Drehhebel 41 verbundene, im wesentlichen parallel zur Längsachse der Pinole 4 geführte Stößelstangen 60, 61 vorgesehen, die auf das mit dem Ausstoßrohr 32 verbundene Joch 63 wirken.

Am unteren Ende des Austoßrohrs 32 befindet sich im Bereich der die Pinole 4 nach unten hin abschließenden Saugpipette 34 der Ausstoßer 33. Dieser besteht im wesentlichen aus einem Ausstoßerkörper 65 mit einer unteren Führungsbohrung 73 und einem Zangeneinsatz 66 mit einer oberen Führungsbohrung 72 und einer Ausstoßernadel 67.

Die Ausstoßernadel 67 wird vom Ausstoßerkörper 65 so aufgenommen, daß sie mit einem Längsbereich in einer mittleren Bohrung 72 des Ausstoßerkörpers 65 geführt ist. Koaxial zur Ausstoßernadel 67 ist eine auf Druck beanspruchte Schraubenfeder 74 innerhalb des Ausstoßerkörpers 65 angeordnet, die sich mit einem Ende an dem Zangeneinsatz 66 und mit dem anderen Ende an einem mit der Ausstoßernadel 67 fest verbundenen Ansatz 75 abstützt, so daß diese unter Vorspannung am Innenrand 76 des Absatzes 70 anliegt.

Der Ausstoßer 33 wird als vormontierte Einheit mit dem Austoßrohr 32 verbunden und von einer Aufnahmebohrung 68 aufgenommen.

Durch einen Vakuumanschluß 77 in dem mit dem Ausstoßrohr 32 verbundenen Joch 63 liegt im Innern des Ausstoßrohrs 32 ein Vakuum vor. Dieses wird gegenüber der Pinole 4 durch einen am Umfang des Ausstoßerkörpers 65 angeordneten O-Ring 141 und gegenüber der Saugbohrung 38 der Pipette 34 mit einem eine Dichtlippe 79 aufweisenden Dichtring 80 des Ausstoßerkörpers 65 abgedichtet.

In der unteren Totlage 54 des Ausstoßrohrs 32 liegt der Dichtring 80 mit leicht gestauchter Dichtlippe 79 an einem Pipettenabsatz 81 an und dichtet so ab. Die Schraubenfeder 74 ist so ausgelegt, daß einerseits das entgegenwirkende Vakuum überwunden wird, und zum anderen durch das Herausfedern der Austoßernadel 67 ein an der Saugbohrung 38 anliegendes Bauteil abgedrückt wird.

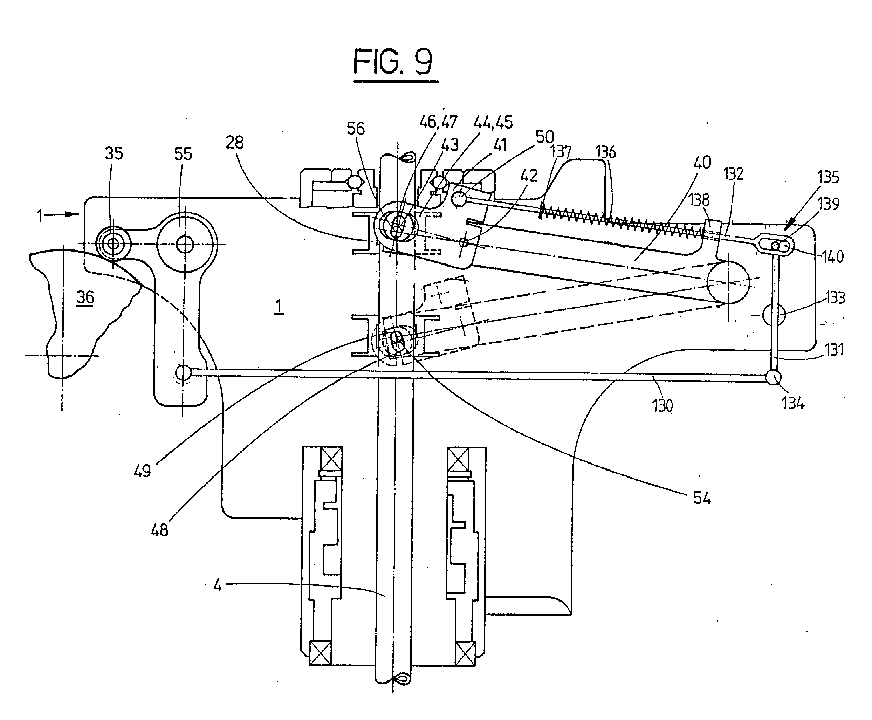

Figur 9 zeigt ein weiteres bevorzugtes Ausführungsbeispiel des Stellgetriebes 17. Hierbei ist der über die Abtastrolle 35 die Kurvenscheibe 36 abtastende Steuerhebel 55 über einen Stellhebel 130, einen Schwenkhebel 131 und eine Stange 132 mit dem Drehhebel 41 im Anlenkpunkt 50 verbunden.

Der im Rahmen 1 in einem Drehlager 133 gelagerte Schwenkhebel 131 ist an einem Ende über ein Drehgelenk 134 mit dem Stellhebel 130 verbunden und am anderen Ende über eine Gelenkverbindung 135 an die Stange 132 angelenkt. Von der Stange 132 wird eine Zugfeder 136 aufgenommen, die mit ihrem einen Ende an der Stange 132 eingehängt ist und mit ihrem anderen Ende an den Hubhebel 40 verbunden ist.

Um sicherzustellen, daß die durch einen entsprechenden Ausschlag des Steuerhebels 55 zugbelastete Stange 132 in der Ruhestellung der Ausstoßvorrichtung 31, also wenn der Drehhebel 41 nach unten verschwenkt ist, entlastet ist, ist die Gelenkverbindung 135 als Langlochverbindung ausgeführt. Das in dieser Verbindung zwischen einem Gelenkzapfen 139 und einem Langloch 41 vorhandene Spiel ist in jedem Fall ausreichend, um eventuell in der Hebelkinematik des Stellgetriebes 17 vorhandene Toleranzen auszugleichen und die Stange 132 zu entlasten. Nur so ist wirklich sichergestellt, daß der Dichtring 80 der Ausstoßvorrichtung 31 mit der größtmöglichen, durch die Zugfeder 136 erzeugten Dichtkraft zur Abdichtung des Vakuums am Pipettenabsatz 81 anliegt.

Zur Aufnahme der infolge der Stellgetriebe 14, 15, 16, 17 die Pinole 4 belastenden Steuermomente sind in der unteren und der oberen Pinolenführung 2, 3 Wälzlager zur axialen Führung der Pinole vorgesehen. Hierduch ist ein bei der Verwendung von Gleitlagerungen mögliches Verkanten der Pinole 4 in den Lagerstellen ausgeschlossen.

Die untere Pinolenführung 2, in deren Bereich die Pinole 4 einen quadratischen Querschnitt aufweist, ist mit vier Kugellagern 82, 83, 84, 85 versehen, die auf senkrecht zur Längsrichtung der Pinole 4 ausgerichteten Achsen 86, 87, 88, 89 angeordnet sind. Zwei benachbarte Kugellager 82, 83 sind als Doppelkugellager ausgeführt und nehmen auf ihren jeweils zwei Außenringen 90, 91 bzw. 92, 93 jeweils einen Führungsring 94, 95 auf.

Die Kugellager 82, 83, 84, 85 sind jeweils einer Ecke des viereckigen Querschnitts der Pinole 4 gegenüberliegend angeordnet und rollen mit Außenringen 96, 97 bzw. ihren Führungsringen 94, 95 auf in den Ecken parallel zur Längsachse der Pinole 4 angeordneten Stahlnadeln 98, 99, 100, 101 ab.

Die Stahlnadeln 98, 99, 100, 101 sind in entsprechenden Ausnehmungen 102, 103, 104, 105 der aus Aluminium gefertigten Pinole 4 angeordnet und mit dieser verklebt.

Zur Fixierung der Drehlage der Pinole 4 gegenüber dem Drehstern 6 weist der Führungsring 94 eine V-förmig eingeschnittenen Querschnitt auf. Hierdurch wird eine zweiseitige Anlage des Führungsrings 94 an die Stahlnadel 98 erreicht, womit die Ausrichtung der Pinole 4 gegenüber dem Drehstern 6 in der Ebene senkrecht zur Längsachse der Pinole 4 exakt festgelegt ist.

Um ein Nachstellen der Führung zu ermöglichen, sind die Achsen 88, 89 der benachbarten Kugellager 84, 85 als Excenter 106, 107 ausgeführt, so daß durch ein Verdrehen der Achsen 88, 89 der Abstand der Kugellager 84, 85 zur Längsachse der Pinole 4 einstellbar ist. Über Gewindestifte 108, 109 ist diese Einstellung fixierbar.

Die mit den Führungsringen 94, 95 versehenen Kugellager 82, 83 sind mit Einstellvorrichtungen 110, 111 versehen, die jeweils aus zwei beidseitig der Kugellager 82, 83 angeordneten, über Federkissen 112, 113 bzw. 114, 115 auf die Achsen 86, 87 wirkenden Gewindestiften 116, 117 bzw. 118, 119 bestehen.

Diese Anordnung hat den Vorteil, daß aufgrund der Federwirkung ein sattes Anliegen jeweils zweier gegenüberliegender Kugellager 82, 84 und 83, 85 erreicht wird, ohne daß die Gefahr der Lagerüberlastung besteht.

Im Bereich der oberen Pinolenführung 3 weist die Pinole 4 einen Kreisringquerschnitt auf. Daher reichen hier drei auf Achsen 120, 121, 122 angeordnete, gleichmäßig über den Umfang der Pinole 4 verteilte Kugellager 123, 124, 125 zur exakten axialen Führung aus. Um den Toleranzausgleich der Bohrungen und eine elastische Vorspannung zu erhalten, ist die Achse 120 des Kugellagers 123 in Gummiringen 126, 127 gelagert.

Zur radialen Lagerung der oberen Pinolenführung 3 im Rahmen 1 des Montagekopfs ist die Pinolenführung 3 in einem Bereich als Lagerhalter 128 in einer Kugelringführung 129 ausgebildet.

Natürlich ist es auch denkbar, das als Stahlband 52 bzw. Hebel 130 ausgeführte Stellglied des Stellgetriebes 17 als ein Leichtbauteil mit in Belastungsrichtung orientiertem Aufbau auszubilden. Hierzu bietet sich in besonderem Maße der Einsatz von faserverstärkten Kunststoffen an. Da deren spezifische Festigkeitswerte teilweise erheblich über den entsprechenden Stahlwerten liegen, ließe sich hiermit eine noch größere Massenreduzierung erzielen.

## Patentansprüche

1. Montagekopf für Handhabungsgeräte zum programmgesteuerten automatischen Montieren von Einzelteilen auf einem Werkstück, insbesondere zum Bestücken von Leiterplatten mit elektronischen Bauteilen, mit einer in einer zentralen Bohrung (5) eines drehbar im Montagekopf gelagerten Drehsterns (6) längsverfahrbaren Pinole (4), mindestens einem in Richtung auf eine am unteren Ende der Pinole (4) angeordnete Saugpipette (34) schwenkbaren Zangenpaar (18, 19) zum Halten und Justieren des Bauteils und einer in der Pinole (4) geführten, über ein Stellgetriebe (16) synchron zum Verfahren der Pinole (4) betätigbaren Ausstoßvorrichtung (31) zum Ablösen eines vom Montagekopf aufgenommenen Bauteils und zum Vakuumabschluß der Saugpipette (34),
**dadurch gekennzeichnet**, daß
die in der Pinole (4) geführte Ausstoßvorrichtung (31) über ein zugbelastetes Stellglied (52, 130) betätigbar ist.

2. Montagekopf nach Anspruch 1 , **dadurch gekennzeichnet**, daß das Stellglied (52, 130) Bestandteil des am Rahmen (1) des Montagekopfs angelenkten Stellgetriebes (17) zur Betätigung der Ausstoßvorrichtung (31) ist, derart, daß das Stellglied (52, 130) zur kraftschlüssigen Verbindung eines über eine Kurvenscheibe (36) angetriebenen Steuerhebels (55) mit einem die Ausstoßvorrichtung (31) über Stößel (60, 61) betätigenden Drehhebel (41) dient, wobei dieser schwenkbar in einem Drehgelenk (42) mit einem die Verfahrbewegung der Pinole (4) ermöglichenden Hubhebel (40) verbunden ist.

3. Montagekopf nach Anspruch 1 oder 2, **dadurch gekennzeichnet**, daß das Stellglied als Stahlband (52) ausgeführt ist.

4. Montagekopf nach einem der vorangehenden Ansprüche, **dadurch gekennzeichnet**, daß der Steuerhebel (55) und der Hubhebel (40) einander gegenüberliegend zu beiden Seiten der Pinole (4) angeordnet sind, und das Stahlband (52) im Bereich des den Hubhebel (40) aufnehmenden Schwenklagers (39) umgelenkt ist.

5. Montagekopf nach einem der vorangehenden Ansprüche, **dadurch gekennzeichnet**, daß der parallel zum Hubhebel (40) angeordnete Drehhebel (41) Achsstummel (43) eines die Pinole (4) umfassenden, zur Anlenkung des Hubhebels (40) an derselben dienenden Hubrings (28) in Langlöchern (46, 47) seiner beiden Schenkel (44, 45) aufnimmt.

6. Montagekopf nach einem der vorangehenden Ansprüche, **dadurch gekennzeichnet**, daß eine am Hubhebel (40) befestigte Druckfeder (51) auf einen Anlenkpunkt (50) des Stahlbands (52) am Drehhebel (41) wirkt, die diesen in eine gegenüber dem Hubhebel (40) abgeknickte Position zwingt, die einen Anschlag für die eine Schwenkbewegung des Drehhebels (41) bewirkt und an die Achspinole anschlägt.

7. Montagekopf nach einem der vorangehenden Ansprüche, **dadurch gekennzeichnet**, daß der Umschlingungswinkel des Stahlbands (52) am Lagermittelpunkt eines zur Lagerung des Hubhebels (40) dienenden Schwenklagers (39) endet.

8. Montagekopf nach einem der vorangehenden Ansprüche, **dadurch gekennzeichnet**, daß das Stellglied als Stellhebel (130) ausgeführt ist und die Bewegung des Stahlbandes nachvollzieht.

9. Montagekopf nach einem der vorangehenden Ansprüche, **dadurch gekennzeichnet**, daß der Stellhebel (130) den Steuerhebel (55) mit einem Schwenkhebel (131) verbindet, der wiederum über eine Gelenkverbindung (135) mit einer durch eine Zugfeder (136) belastete, am Drehhebel (41) angelenkte Stange (132) verbunden ist.

10. Montagekopf nach einem der vorangehenden Ansprüche, **dadurch gekennzeichnet**, daß die Gelenkvebindung (135) aus einem in einem Langloch (140) der Stange (132) geführten Gelenkzapfen (139) des Schwenkhebels (131) besteht.

11. Montagekopf nach einem der vorangehenden Ansprüche, **dadurch gekennzeichnet**, daß die Zugfeder (136) auf der Stange (132) eingehängt ist und mit einem Ende mit dem Hubhebel (40) verbunden ist.

12. Montagekopf nach einem der vorangehenden Ansprüche, **dadurch gekennzeichnet**, daß die Pinole (4) in Wälzlagern axial verschiebbar geführt ist.

13. Montagekopf nach Anspruch 12, **dadurch gekennzeichnet**, daß die Pinole (4) sowohl in einer unteren Pinolenführung (2) als auch in einer oberen Pinolenführung (3) in Kugellagern (82..85; 123..125) längsverschiebbar geführt ist.

14. Montagekopf nach einem der vorangehenden Ansprüche, **dadurch gekennzeichnet**, daß die im Bereich der oberen Pinolenführung (3) einen Kreisringquerschnitt aufweisende Pinole (4) in drei gleichmäßig am Umfang der Pinole (4) verteilten Kugellagern (123..125) in einem Lagerhalter (128) axial geführt ist, wobei dieser in einer Kugelringführung (129) gehalten ist.

15. Montagekopf nach einem der vorangehenden Ansprüche, **dadurch gekennzeichnet**, daß die im Bereich der unteren Pinolenführung (2) einen quadratischen Querschnitt aufweisende Pinole (4) in vier jeweils den Ekken des quadratischen Querschnitts zugeordneten Kugellagern (82..85) geführt ist, wobei in den Ecken sich in Längsrichtung der Pinole (4) erstreckende Stahlnadeln (98..101) vorgesehen sind.

16. Montagekopf nach einem der vorangehenden Ansprüche, **dadurch gekennzeichnet**, daß zwei als vorgespannte Doppelkugellager ausgeführte Kugellager (82, 83) mit jeweils zwei Außenringen (90, 91; 92, 93) versehen sind zur Aufnahme jeweils eines Führungsrings (94, 95), von denen mindestens einer einen V-förmig eingeschnittenen Querschnitt aufweist zur Zweipunktanlage an eine Stahlnadel (98, 99).

17. Montagekopf nach einem der vorangehenden Ansprüche, **dadurch gekennzeichnet**, daß die Kugellager (82..85) bezüglich ihres Abstands von der Pinolenlängsachse einstellbar sind.

## Claims

1. Assembly head for handling appliances for the program-controlled automatic fitting of individual parts on a workpiece, more particularly for fitting conductor plates with electronic components, with a spindle (4) longitudinally movable in a central bore (4) of a rotary star (6) mounted rotatable in the assembly head, at least one pair of pincers (18,19) which can swivel in the direction of a suction pipette (34) mounted at the lower end of the spindle (4) for holding and adjusting the component, and with an ejector device (31) guided in the spindle (4) and actuated by a servo gearing (16) in synchronization for moving the spindle (4) to release a component held by the assembly head and to vacuum seal the suction pipette (34), characterised in that
the ejector device (31) guided in the spindle (4) can be actuated by a traction-loaded setting member (52, 130).

2. Assembly head according to claim 1 characterised in that the setting member (52, 130) is a constituent part of the servo gear (17) attached to the frame (1) of the assembly head for operating the ejector device (31) so that the setting member (52, 130) serves for the force-locking connection of a control lever (55) driven by a cam disc (36) with a rotary lever (41) operating the ejector device (31) through rams (60,61) wherein this rotary lever (41) is connected swivelling in a rotary joint (42) with a lift lever (40) which allows the movement of the spindle (4).

3. Assembly head according to claim 1 or 2 characterised in that the setting member is designed as a steel band (52).

4. Assembly head according to one of the preceding claims, characterised in that the control lever (55) and the lift lever (40) are mounted opposite one another either side of the spindle (4) and the steel band (52) is deflected in the area of the swivel bearing (39) which takes up the lift lever (40).

5. Assembly head according to one of the preceding claims, characterised in that the rotary lever (41) mounted parallel to the lift lever (40) holds the axle shaft (43) of a lift ring (28) enclosing the spindle (4) and serving to attach the lift lever (40) to same, in oblong holes (46,47) of its two arms (44,45).

6. Assembly head according to one of the preceding claims, characterised in that a compression spring (51) fixed on the lift lever (40) acts on a connecting point (50) of the steel band (52) on the rotary lever (41) and forces this into a position bent down opposite the lift lever (40) which causes a stop for the one swivel movement of the rotary lever (41) and stops on the axle spindle.

7. Assembly head according to one of the preceding claims, characterised in that the contact loop angle of the steel band (52) ends at the bearing centre point of a swivel lever (39) serving to support the lift lever (40).

8. Assembly head according to one of the preceding claims, characterised in that the setting member is designed as a servo lever (130) and completes the movement of the steel band.

9. Assembly head according to one of the preceding claims, characterised in that the servo lever (130) connects the control lever (55) to a swivel lever (131) which in turn is connected by an articulated connection (135) to a rod (132) which is attached to the rotary lever (41) and loaded by a tension spring (136).

10. Assembly head according to one of the preceding claims, characterised in that the articulated connection (135) consists of an articulated pivot (139) of the swivel lever (131) guided in an oblong hole (140) of the rod (132).

11. Assembly head according to one of the preceding claims, characterised in that the tension spring (136) is suspended from the rod (132) and is connected at one end to the lift lever (40).

12. Assembly head according to one of the preceding claims, characterised in that the spindle (4) is guided axially displaceable in rolling bearings.

13. Assembly head according to claim 12, characterised in that the spindle (4) is guided longitudinally displaceable both in a lower spindle guide (2) and in an upper spindle guide (3) in ball bearings (82...85; 123...125).

14. Assembly head according to one of the preceding claims, characterised in that the spindle (4) having a circular ring cross-section in the area of the upper spindle guide (3) is axially guided in a bearing holder (128) in three ball bearings (123...125) spaced evenly round the circumference of the spindle (4) wherein the bearing holder is held in a ball ring guide (129).

15. Assembly head according to one of the preceding claims, characterised in that the spindle (4) having a square cross-section in the area of the lower spindle guide (2) is guided in four ball bearings (82...85) each associated with a corner of the square cross-section wherein steel needles (98...101) are provided in the corners extending in the longitudinal direction of the spindle (4).

16. Assembly head according to one of the preceding claims, characterised in that two ball bearings (82, 83) designed as pretensioned double ball bearings are each provided with two outer rings (90,91; 92,93) each to hold a guide ring (94, 95) of which at least one has a V-shaped cut-in cross-section for the two-point bearing against a steel needle (98,99).

17. Assembly head according to one of the preceding claims, characterised in that the ball bearings (82..85) are adjustable with regard to their distance from the spindle longitudinal axis.

## Revendications

1. Tête de montage de manipulateurs pour le montage automatique, commandé par programme, de pièces détachées sur une construction et, en particulier, pour équiper des plaques conductrices de composants électroniques avec une douille vide pouvant se déplacer longitudinalement et pouvant tourner dans un alésage central (5) d'une étoile tournante (6) montée dans la tête de montage avec au moins une paire de pinces (18, 19) pivotantes dans la direction d'une pipette aspirante (34) disposée à l'extrémité inférieure de la douille (4) pour maintenir et ajuster le composant et avec un dispositif d'extraction (31) guidé dans la douille (4) et pouvant être actionné en synchronisme avec le déplacement de la douille (4) au moyen d'une transmission de réglage (16) pour enlever un composant monté sur la tête de montage et pour supprimer le vide dans la pipette aspirante (34),
caractérisée en ce que le dispositif d'extraction (31) guidé dans la douille (4) peut être actionné au moyen d'un élément de réglage (52, 130) soumis à traction.

2. Tête de montage selon la revendication 1,
caractérisée en ce que l'élément de réglage (52, 130) fait partie de la transmission de réglage (17) articulée au châssis (1) de la tête de montage pour actionner le dispositif d'extraction (31) de façon que l'élément de réglage (52, 130) assure l'assemblage mécanique d'un levier de commande (55) commandé par une came (36) avec un levier pivotant (31) actionnant le dispositif d'extraction (31) par l'intermédiaire de poussoirs (60, 61) dans lequel celui-ci est assemblé à pivot dans une articulation pivotante (42) avec un levier de soulèvement (40) permettant le mouvement de déplacement de la douille (4).

3. Tête de montage selon la revendication 1 ou 2, caractérisée en ce que l'élément de réglage est constitué par une bande d'acier (52).

4. Tête de montage selon l'une des revendications précédentes, caractérisée en ce que le levier de commande (55) et le levier de soulèvement (40) sont disposés l'un en face de l'autre, de part et d'autre de la douille et que la bande d'acier (52) subit un changement de direction dans la zone du support pivotant (39) recevant le levier de soulèvement (40).

5. Tête de montage selon l'une des revendications précédentes, caractérisée en ce que le levier pivotant (41), disposé parallèlement au levier de soulèvement (40) reçoit dans les trous allongés (46, 47) de ses deux branches (44, 45) les bouts d'axe (43) d'une bague de soulèvement (28) entourant la douille (4) et servant à articuler le levier de soulèvement (40) à celle-ci.

6. Tête de montage selon l'une des revendications précédentes, caractérisée en ce qu'un ressort de pression (51), fixé au levier de soulèvement (40) agit au point d'articulation (50) de la bande d'acier (52) sur le levier pivotant (41) qui pousse celle-ci dans une position écartée du levier de soulèvement (40), ladite position créant une butée pour un mouvement de pivotement du levier de pivotement (41) et venant buter sur la douille de l'axe.

7. Tête de montage selon l'une des revendications précédentes, caractérisée en ce que l'angle d'enroulement de la bande d'acier (52) se termine au point central du support pivotant (39) servant à supporter le levier de soulèvement (40).

8. Tête de montage selon l'une des revendications précédentes, caractérisée en ce que l'élément de réglage est constitué par un levier de réglage (130) et achève le déplacement de la bande d'acier.

9. Tête de montage selon l'une des revendications précédentes, caractérisée en ce que le levier de réglage (130) assemble le levier de commande (55) à un levier pivotant (131) qui est assemblé à son tour par un assemblage articulé (135) avec une tringle (132) soumise à l'action d'un ressort de traction (136) et articulée au levier pivotant (41).

10. Tête de montage selon l'une des revendications précédentes, caractérisée en ce que l'assemblage articulé (135) est constitué d'une broche d'articulation (140), du levier pivotant (131) qui est guidé dans un trou allongé (140) de la tringle (132).

11. Tête de montage selon l'une des revendications précédentes, caractérisée en ce que le ressort de traction (136) est accroché à la tringle (132) et est assemblé par une extrémité au levier de soulèvement (40).

12. Tête de montage selon l'une des revendications précédentes, caractérisée en ce que la douille (4) est guidée de manière à coulisser axialement dans les paliers à rouleaux.

13. Tête de montage selon la revendication 12, caractérisée en ce que la douille (4) est guidée de manière à se déplacer longitudinalement dans un guide de douille inférieur (2) ainsi que dans un guide de douille supérieur (3) dans les paliers à bille (82..85; 123..125).

14. Tête de montage selon l'une des revendications précédentes, caractérisée en ce que la douille (4) présentant une section annulaire dans la zone du guide de douille supérieure (3) est guidée axialement dans un support de palier (128) dans trois paliers à billes (123..125) répartis uniformément à la périphérie de la douille (4), ledit support de palier (128) étant maintenu dans un guide de bague à bille (129).

15. Tête de montage selon l'une des revendications précédentes, caractérisée en ce que la douille (4) présentant une section carrée dans la zone du guide de douille inférieure (2) est guidé dans (4) paliers à bille (82..85) disposés chacun dans les angles de la section carrée, tandis qu'il existe des aiguilles d'acier (98..101) disposées dans les angles et s'étendant dans la direction longitudinale de la douille (4).

16. Tête de montage selon l'une des revendications précédentes, caractérisée en ce que deux paliers à billes (82, 83), construits sous forme de paliers à billes doubles précontraints sont pourvus chacun de deux bagues extérieures (90, 91; 92, 93) destinées à recevoir chacune une bague de guidage (94, 95) dont au moins l'une présente une section avec encoche en forme de V pour servir d'appui en deux points pour une aiguille d'acier (98, 99).

17. Tête de montage selon l'une des revendications précédentes, caractérisée en ce que les paliers à billes (82..85) peuvent être réglés pour ce qui concerne leur distance par rapport à l'axe longitudinal de la douille.
